# EUROPÄISCHE PATENTSCHRIFT

(11) **EP 1 253 621 B1**
(45) Veröffentlichungstag und Bekanntmachung des Hinweises auf die Patenterteilung: **05.10.2011**
(21) Anmeldenummer: 02008643.5
(22) Anmeldetag: 17.04.2002
(51) Int. Cl.: H01J 37/32

(54) **Vorrichtung zur Erzeugung eines Niedertemperatur-Plasmas**
Low temperature plasma generating device
Dispositif de génération d'un plasma à basse température

(30) Priorität: 25.04.2001 DE 10120405
(43) Veröffentlichungstag der Anmeldung: 30.10.2002
(73) Patentinhaber: Reinhausen Plasma GmbH, 93057 Regensburg (DE)
(72) Erfinder: Engemann, Jurgen Prof.Dr.Dr.h.c., 42119 Wuppertal (DE); Schwabedissen, Axel Dr., 42111 Wuppertal (DE)
(74) Vertreter: Meier, Gerald Heinz

(56) Entgegenhaltungen:
- EP-A- 0 881 865
- US-A- 878 425
- US-A- 6 066 826

## Beschreibung

Die Erfindung betrifft eine Vorrichtung zur Erzeugung eines Niedertemperatur-Plasmas gemäß dem Oberbegriff des Anspruches 1.

Insbesondere betrifft die Erfindung eine Vorrichtung zur Erzeugung eines großvolumigen Niedertemperatur-Plasmas.

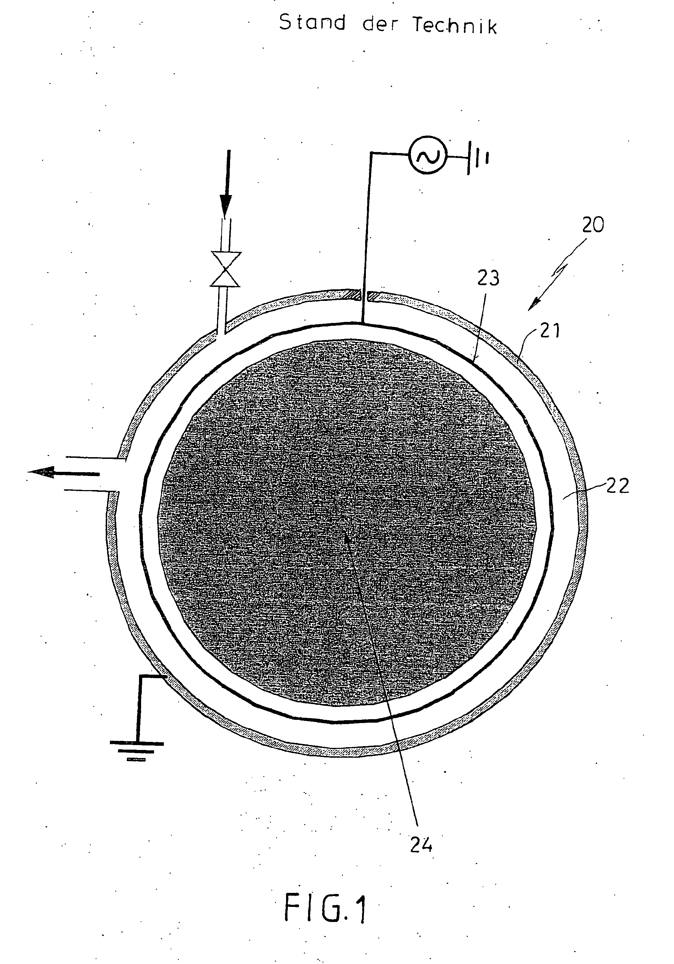

Eine Vorrichtung gemäß dem Oberbegriff des Anspruches 1 ist bekannt jedoch druckschriftlich nicht belegbar. Der besseren Verständlichkeit halber wurde sie als Fig. 1 skizziert. Hier ist eine hohle Anode vorgesehen, die eine im wesentlichen geschlossene Vakuumkammer ausbildet, innerhalb derer sich eine Kathode befindet. Die Kathode ist ebenfalls hohl ausgebildet und umgibt einen Prozeßraum.

Als hohle Anode wird hierbei ein hohles, kreiszylindrisches Element bezeichnet, welches die Wand der Vakuumkammer ausbildet. Die Vakuumkammerwand ist dabei als Anode geschaltet und geerdet. Es handelt sich bei der hohlen Anode jedoch nicht um eine Hohlanode im Sinne der. Gasentladungsphysik.

Die bekannte Vorrichtung arbeitet mit kapazitiv gekoppelten Niederdruck-Glimmentladungen, die mit Hochfrequenz angeregt werden.

Glimm-Entladungen spielen eine wichtige Rolle im Bereich der Halbleiter-Herstellung, der Plasmasterilisation und der Behandlung von Kunststoffen und Metallen, wobei insbesondere auch auf die Reinigung von Oberflächen und eine Verbesserung von Oberflächeneigenschaften, wie Adhäsion, Benetzbarkeit, Verklebbarkeit und Reibungs- bzw. Verschleißschutz hingewiesen wird.

Mit dieser bekannt gewordenen Vorrichtung ist bereits versucht worden, großvölumige homogene Plasmen zu erzeugen. Das in dem Prozeßraum erzeugte Plasma zeigt jedoch eine ungleichmäßige Verteilung der Plasmadichte. Die Plasmadichte im Zentrum der Vakuumkammer ist wesentlich geringer als in der Nähe der Kathode. Daraus ergibt sich - mit zunehmendem Volumen - eine inhomogene und unzureichende Modifikation der Oberflächeneigenschaften bzw. eine unverhältnismäßig lange Behandlungszeit, um die niedrige Plasmadichte im Zentrum der Kammer auszugleichen.

Der Erfindung liegt die Aufgabe zu Grunde, ausgehend von dem eingangs erwähnten Stand der Technik eine Vorrichtung zur Erzeugung eines Niedertemperatur-Plasmas zu schaffen, welche ein großvolumiges homogenes Plasma, insbesondere gleichmäßiger Plasmadichte, bereitstellt.

Die Erfindung löst diese Aufgabe mit den Merkmalen des Anspruches 1, und ist demnach dadurch gekennzeichnet, daß die Kathodenanordnung eine Vielzahl von zu dem Prozeßraum hin offenen, taschenartigen Kammern umfasst, die eine Vielzahl von Einzel-Hohlkathoden bilden.

Das Prinzip der Erfindung besteht somit im wesentlichen darin, innerhalb der Vakuumkammer eine Vielzahl von Einzel-Hohlkathoden vorzusehen. Die Einzel-Hohlkathoden begrenzen dabei einen großvolumigen Prozeßraum zumindest teilweise.

Erfindungsgemäß wird die Erzeugung eines großvolumigen Niedertemperatur-Plasmas auf der Basis von Hohlkathoden-Hochfrequenz-Entladungen möglich. Als Niedertemperatur-Plasma wird in diesem Zusammenhang ein Plasma bezeichnet, bei dem das Arbeitsgas, das sogenannte Neutralgas, eine Temperatur etwa im Bereich der Temperatur der Vakuumkammerwand aufweist.

Die eingangs erwähnte Vorrichtung des Standes der Technik arbeitet nicht mit Hohlkathoden-Entladungen, sondern mit kapazitiv gekoppelten Niederdruck-Glimmentladungen. Zwar wird auch erfindungsgemäß ein kapazitiv gekoppeltes Plasma verwendet, allerdings entsteht hier erst durch die gewählte Geometrie ein Hohlkathodeneffekt, der beim Stand der Technik nicht entstand. Eine Hohlkathode war dort nicht vorgesehen.

Erfindungsgemäß ist der Prozeßraum der Vorrichtung großvolumig. Als großvolumiger Prozeßraum wird dabei insbesondere ein Prozeßraum bezeichnet, der ein Volumen von mehr als 50 I bis zu einigen hundert Litern aufweist, grundsätzlich aber auch bis zu über 1000 I aufweisen kann. Mit der erfindungsgemäßen Vorrichtung werden Prozeßräume mit einem Volumen bis über 1000 I möglich, die ein homogenes, gleichmäßig dichtes Plasma erzeugen können.

Die Vakuumkammer ist insbesondere geerdet und bis auf eine Öffnung zum Anschluß einer Vakuumpumpe, eine Öffnung zum Einlaß einer Arbeitsgases und eine Öffnung zur Zuleitung von hochfrequenter Leistung vollständig geschlossen. Andere Zuführungen, wie z.B. Drucksensoren, sind ebenso möglich. Während des Betriebs befindet sich die Vakuumkammer und damit auch der Prozeßraum unter Vakuum.

Die Kathodenanordnung befindet sich innerhalb der Vakuumkammer, so daß die hohle Anode die Kathodenanordnung im wesentlichen umgibt. Die Kathodenanordnung begrenzt dabei zumindest teilweise den Prozeßraum. Es ist dabei insbesondere vorgesehen, daß der Prozeßraum von der Kathodenanordnung nur teilweise begrenzt wird und im übrigen von der Anode begrenzt wird. Als Anode, insbesondere als hohle Anode, wird wiederum die geerdete Wand der Vakuumkammer bezeichnet.

Die taschenartigen Kammern sind jeweils mit ihrer offenen Seite zum Prozeßraum hin gerichtet. Die Form der taschenartigen Kammer ist dabei zunächst beliebig. So kann die Kammer beispielsweise muldenartig ausgebildet sein und eine gekrümmte Innenfläche, grundsätzlich aber auch zwei ebene unter einem Winkel zueinander stehende Flächen umfassen. Insbesondere können die Kammern auch profilartig langgestreckt ausgebildet sein, so daß sie halbzylindrische Räume bilden.

Hohlkathodenentladungen stellen eine spezielle Form von Gasentladungen dar, die unabhängig von der Anregungsart Plasmen mit hoher Elektronendichte erzeugen. Die Erhöhung der Elektronendichte durch den Hohlkathodeneffekt wird verursacht durch eine gegenseitige Durchdringung des negativen Glimmlichts, welches von verschiedenen Teilen der Teilen der Kathode ausgeht. Hieraus resultiert eine Pendelbewegung der Elektronen im elektrischen Feld. Von Gleichstrom-Hohlkathodenentladungen wird schön sehr früh berichtet, beispielsweise im Aufsatz von Günther-Schulze, Zeitschrift für Physik 30, Seite 175-186 (1924). Im Aufsatz von Little und von Engel, Proc. Roy. Soc. 224, Seite 209-227 (1954) wird erstmals eine Theorie für Gleichstrom-Hohlkathodenentladungen entwickelt. Der Aufsatz von Pillow, Spectrochemica Acta 36 B, Seite 821-843 (1981) gibt einen Überblick über die diversen physikalischen Eigenschaften von Gleichstrom-Hohlkathodenentladungen.

Gleichstromentladungen sind nicht für Prozesse geeignet, bei denen sich ein Isolator zwischen den Elektroden befindet oder bei denen eine isolierende Schicht auf einem Substrat, das als Elektrode dient, deponiert wird. In einem Aufsatz von Horwitz in Appl. Phys. Lett. 43 (10), Seite 977-979 (1983) wird erstmals von Hohlkathodenentladungen berichtet, die mit hochfrequenter Leistung betrieben werden. Mit der dort beschriebenen Vorrichtung werden Ätzprozesse in einem kleinen Volumen von ca. 5 Liter durchgeführt.

Als Faustregel für das Auftreten des Hohlkathodeneffektes gilt p x d = 1 mbar x cm, wobei p der Gasdruck und d der Abstand oder Durchmesser der Hohlkathode ist. Um den Druckbereich zu vergrößern, in dem der Hohlkathodeneffekt auftritt, beschreiben Fukuda et al. in einem Aufsatz in Jpn. J. Appl. Phys 35, Seite L 729 - 730, (1996) eine Hohlkathodengeometrie spezieller Art. Die Hohlkathode hat hierbei ein spitz zulaufendes, V-förmiges Profil. Dieses Profil bewirkt, daß - je nach Gasdruck - das negative Glimmlicht der Hohlkathodenentladung sich mehr oder weniger tief in das V-Profil zurückzieht. Fukuda et al. verwendeten nur ein einziges V-förmiges Profil der Länge 10 cm, das Plasmavolumen beträgt ca. 1 bis 2 Liter.

Weitere Vorrichtungen zur Erzeugung von geringvolumigen Plasmen sind ebenfalls bekannt und beispielsweise in der DE 197 226 24 beschrieben. Hier werden Niedertemperatur-Plasmajets erzeugt, die aus einer Hohlkathodenkammer extrahiert werden. Die Hohlkathode und die Anode weisen hier einander gegenüberliegende Öffnungen auf, durch die die Plasmajets von der Hohlkathodenkammer in einen Prozeßraum gelangen. Derartige Vorrichtungen sind zwar zur Erzeugung von großflächigen, nicht aber zur Erzeugung von großvolumigen Plasmen geeignet. Insbesondere wird hier der Prozeßraum nicht zumindest teilweise von einer Kathodenanordnung begrenzt.

Dokument US 6 066 826 beschreibt eine weitere Plasma-Erzeugungsvorrichtung mit einer Kathodenanordnung, die eine Vielzahl von zu dem Prozessraum hin offenen, taschenartigen Kammern umfasst, die eine Vielzahl von Einzel-Hohlkathoden bilden.

Gemäß einer vorteilhaften Ausgestaltung der Erfindung sind zumindest einige taschenartige Kammern nahe der inneren Wandflächen der Anode angeordnet. Dies bietet den Vorteil, den Prozeßraum nahezu so groß wie die Vakuumkammer gestalten zu können.

Gemäß einer weiteren vorteilhaften Ausgestaltung der Erfindung sind mehrere taschenartige Kammern entlang einer Ebene angeordnet. Dies bietet die Möglichkeit mehrere Kammern einem einzigen Konstruktionselement, beispielsweise an einer zusammenhängenden Elektrode, auch z.B. an einem gemeinsamen Elektrodenblech, vorzusehen.

Gemäß einer weiteren vorteilhaften Ausgestaltung der. Erfindung sind die taschenartigen Kammern entlang unterschiedlicher Ebenen angeordnet. Dies bietet die Möglichkeit; eine Vielzahl von taschenartigen Kammern, beispielsweise durch Anordnung mehrerer, die Kathodenanordnung ausbildender Elektrodenbleche vorzusehen, wobei die Elektrodenbleche in nebeneinander liegender, oder übereinander liegender Anordnung vorgesehen sind. Dies bietet hinsichtlich der Konstruktion der Kathodenanordnung sowie der Plasmahomogenität erhebliche Vorteile.

Gemäß einer vorteilhaften Ausgestaltung der Erfindung wird die Kathodenanordnung von mindestens einem gefalteten oder gewellten Elektrodenblech gebildet, welches die taschenartigen Kammern aufweist. Diese Ausbildung bietet den Vorteil einer besonders einfachen Konstruktion der taschenartigen Kammern.

Gemäß einer weiteren vorteilhaften Ausgestaltung der Erfindung ist der Prozeßraum von der Kathodenanordnung in mehrere Sub-Prozeßräume unterteilt. Auf diese Weise wird ein besonders großvolumiger Prozeßraum möglich, der mehrere kleinere Sub-Prozeßräume umfaßt. In derartige Sub-Prozeßräume können beispielsweise mehrere, unterschiedliche Transportkörbe eines Transportwagens eingebracht werden, so daß eine besonders einfache. Konstruktion eines Transportwagens zur Einbringung von zu bearbeitenden Gütern auf einfache Weise möglich wird und eine besonders einfache Elektrodenkonfiguration für einen großvolumigen Prozeßraum möglich wird. Das Vorsehen von Sub-Prozeßräumen erhöht außerdem die Gleichmäßigkeit der Plasmaausbildung bzw. der Plasmadichte.

Gemäß einer besonders vorteilhaften Ausgestaltung der Erfindung ist wenigstens eine taschenartige Kammer mit ihrer offenen Seite zu einem ersten Sub-Prozeßraum hin gerichtet und wenigstens eine weitere taschenartige Kammer mit ihrer offenen Seite zu einem zweiten Sub-Prozeßraum hin gerichtet. Diese Anordnung ermöglicht eine besonders vorteilhafte Kathodenkonfiguration, da mehrere kammerartige Taschen, die zu unterschiedlichen Sub-Prozeßräumen hin gerichtet sind, gemeinsam beispielsweise an einem einzigen Elektrodenblech angeordnet sein können.

Gemäß einer weiteren vorteilhaften Ausgestaltung der Erfindung sind jeweils zwei benachbarte taschenartige Kammern unter Ausbildung einer im wesentlichen W-förmigen Struktur miteinander verbunden. Dies bietet auf besonders einfache Weise die Möglichkeit, taschenartige Kammern für nebeneinander liegende Sub-Prozeßräume vorzusehen, welche durch lediglich ein Elektrodenblech, welches diese taschenartigen Kammern trägt, voneinander getrennt sind.

Gemäß einer weiteren vorteilhaften Ausgestaltung der Erfindung sind eine erste und eine zweite taschenartige Kammer nebeneinander derart angeordnet, daß sie zwischen sich eine dritte, entgegengesetzt gerichtete Kammer ausbilden. Dies bietet die Möglichkeit, eine kompakte Anordnung von taschenartigen Kammern vorzusehen, die sich unterschiedlichen Sub-Prozeßräumen hinwenden und die zugleich auf konstruktiv sehr einfache Weise erzeugbar sind.

Gemäß einer weiteren vorteilhaften Ausgestaltung der Erfindung ist die Vakuumkammer mittels einer Tür, welche Zugang zu dem Prozeßraum bietet, verschließbar. Diese bietet die Möglichkeit auf einfache Weise zu behandelnde Werkstücke in die Vakuumkammer einzubringen und während des Betriebs der Vorrichtung innerhalb der Vakuumkammer aufzubewahren.

Gemäß einer weiteren vorteilhaften Ausgestaltung. der Erfindung ist innerhalb des Prozeßraums ein Transportwagen anordenbar. Dies bietet die Möglichkeit, ein oder mehrere Werkstücke auf einfache Weise in rollendem Transport in die Vakuumkammer einzubringen.

Gemäß einer vorteilhaften Ausgestaltung der Erfindung ist der Transportwagen im Prozeßraum geerdet angeordnet, insbesondere elektrisch mit der Anode verbunden. Dies bietet die Möglichkeit, auf besonders einfache Weise in einem verhältnismäßig großen Prozeßraum eine Unterteilung dieses Prozeßraumes in Sub-Prozeßräume dadurch zu begünstigen, daß der Transportwagen selbst Anodenflächen auf Grund seiner elektrischen Verbindung mit der Anode zur Verfügung stellt.

Gemäß einer weiteren vorteilhaften Ausgestaltung der Erfindung erfolgt die Erdung des Transportwagens über einen Kontakt der Rollen des Transportwagens mit der Anode. Diese Ausgestaltung bietet eine denkbar einfache elektrische Verbindung des Transportwagens mit der Anode, deren Bodenfläche mit den Rollen des Transportwagens in Kontakt gerät. Alternativ kann der elektrische Kontakt auch über einen Schleifkontakt zwischen Transportwagen und Bodenfläche stattfinden. Gemäß einer weiteren vorteilhaften Ausgestaltung der Erfindung ist der Transportwagen im Prozeßraum elektrisch von der Anode isoliert angeordnet. Dies bietet die Möglichkeit, in den Prozeßraum auch solche Transportwagen bzw. zu bearbeitende Werkstücke einzubringen, die nicht elektrisch leitend sind.

Gemäß einer weiteren vorteilhaften Ausgestaltung der Erfindung umfaßt der Transportwagen mehrere Transportkörbe. Dies bietet die Möglichkeit, mit einem einzigen Transportwagen eine Vielzahl von zu bearbeitenden Werkstücken zugleich in die Vakuumkammer einzubringen und gleichzeitig dort zu bearbeiten.

Gemäß einer weiteren vorteilhaften Ausgestaltung der Erfindung entspricht die Anordnung der Transportkörbe einer Anordnung von Sub-Prozeßräumen. Diese Ausgestaltung bietet eine optimale Raumausnutzung des Prozeßraums sowie eine besonders gleichmäßige Plasmadichte.

Gemäß einer weiteren besonders vorteilhaften Ausgestaltung der Erfindung ist die taschenartige Kammer im Querschnitt im wesentlichen dreieckförmig ausgebildet. Dies bietet den Vorteil, daß die taschenartige Kammer auf besonders einfache Weise konstruiert werden kann, beispielsweise indem zwei Schenkelflächen unter einem Winkel zueinander stehend angeordnet werden. Die beiden Schenkelflächen können dabei beispielsweise durch Faltung von flachliegenden Blechen gebildet werden.

Gemäß einer weiteren vorteilhaften Ausgestaltung der Erfindung liegt die Schenkellänge eines Dreiecks zwischen 0,5 und 30 cm. Diese Ausbildung ermöglicht eine besonders optimale Ausnutzung eines Hohlkathodeneffektes. Andere Schenkellängen sind im Prinzip auch möglich.

Gemäß einer weiteren vorteilhaften Ausgestaltung der Erfindung weisen die taschenartigen Kammern Perforationen auf. Dies bietet die Möglichkeit, daß durch die Perforationen hindurch ein Ladungsträgeraustausch zwischen unterschiedlichen Sub-Prozeßräumen stattfinden kann. Außerdem sind gelochte Elektrodenbleche mechanisch auf besonders einfache Weise zu falten. Perforationen bieten darüber hinaus den Vorteil einer gleichmäßigeren Ausbreitung des Neutralgases und des Plasmas im Prozeßraum.

Gemäß einer weiteren vorteilhaften Ausgestaltung der Erfindung sind die taschenartigen Kammern zylindrisch langgestreckt ausgebildet. Es kann sich hierbei beispielsweise um eine offene, halbzylindrische Anordnung mit kreisförmigen Querschnitt, grundsätzlich aber auch mit dreieckförmigen Querschnitt handeln. Diese Ausbildung ermöglicht einen besonders großvolumigen Prozeßraum und damit ein besonders großvolumiges Plasma.

Gemäß einer weiteren vorteilhaften Ausgestaltung der Erfindung ist die Länge der taschenartigen Kammer nur geringfügig kürzer als die Länge der Vakuumkammer. Auch dies ermöglicht einen besonders großen Prozeßraum, der nahezu dem Volumen der Vakuumkammer entsprechen kann.

Gemäß einer weiteren vorteilhaften Ausgestaltung der Erfindung sind die taschenartigen Kammern durch besondere Halterungen elektrisch isoliert von der Anode an der Anode befestigt. Diese Ausbildung bietet insbesondere die Möglichkeit einer besonders einfachen Konstruktion derart, daß Befestigungsmittel nach Art von Haltestangen an der Anode elektrisch isoliert angeordnet sind. Auf diesen Halterungen nach Art von Haltestangen können die Elektrodenbleche, die die taschenartigen Kammern aufweisen, aufliegen oder auf besondere Weise befestigt sein.

Gemäß einer weiteren vorteilhaften Ausgestaltung der Erfindung wird von einem Hochfrequenz-Generator Hochfrequenz-Leistung über Koaxial-Leitungen an die taschenartigen Kammern geleitet. Dies bietet die Möglichkeit, daß auf herkömmliche Komponenten zur Leitung der Hochfrequenzleistung zurückgegriffen werden kann. Im einfachsten Falle kann dabei ein Elektrodenblech, welches die taschenartigen Kammern vorsieht, mit einer Koaxial-Leitung verbunden sein.

Gemäß einer weiteren vorteilhaften Ausgestaltung der Erfindung sind innerhalb der Vakuumkammer Koaxial-Leitungen, insbesondere 50-Ohm-Koaxial-Leitungen, zur Leitung der Hochfrequenzleistung in die taschenartigen Kammern angeordnet. Dies bietet die Möglichkeit, daß auch zur Leitung der Hochfrequenz-Leistung innerhalb der Vakuumkammer auf herkömmliche Komponenten zurückgegriffen werden kann.

Gemäß einer weiteren vorteilhaften Ausgestaltung der Erfindung ist das Plasma gepulst. Dies bedeutet, daß die Amplitude der Hochfrequenz, die den taschenartigen Kammern über Koaxial-Leitungen zugeführt wird und etwa im Bereich von 13,56 MHz auf Grund postalischer Beschränkungen liegt, selbst moduliert ist. Dies bietet den Vorteil einer besonders effektiven Plasmaerzeugung. Andere Frequenzen zwischen 10 KHz und 100 MHz sind möglich.

Weitere Vorteile ergeben sich aus den nicht zitierten Unteransprüchen sowie an Hand der nun folgenden Beschreibung von in den Zeichnungen dargestellten Ausführungsbeispielen. Darin zeigen:
- Fig. 1: schematisch eine Vorrichtung des Standes der Technik,
- Fig. 2: in schematischer, teilgeschnittener Ansicht ein erstes Ausführungsbeispiel der erfindungsgemäßen Vorrichtung mit einem darin eingebrachten Transportwagen,
- Fig. 3: schematisch eine teilgeschnittene Ansicht der Vorrichtung etwa gemäß Schnittlinie III-III in Fig. 2,
- Fig. 4: schematisch einen Teilbereich eines Prozeßraums mit Kathode und einem Teilbereich der Anode,
- Fig. 5: ein zweites Ausführungsbeispiel einer Kathode in Sinusform,
- Fig. 6: ein drittes Ausführungsbeispiel einer Kathode mit im wesentlichen rechteckförmigen; kammerartigen Taschen, die zu unterschiedlichen Sub-Prozeßräumen hingerichtet sind, und
- Fig. 7: ein viertes Ausführungsbeispiel einer Kathode mit im Querschnitt rechteckigförmigen kammerartigen Taschen, die zu einem Prozeßraum hingerichtet sind.

Gleiche bzw. vergleichbare Elemente oder Teile werden in der nun folgenden Beschreibung mit gleichen Bezugsziffern bezeichnet.

Fig. 1 zeigt eine Vorrichtung 20 des Standes der Technik. Hier ist bereits ein kreiszylindrischer Hohlkörper 21 vorgesehen, der eine kreiszylindrische Vakuumkammer 22 definiert. Der Hohlkörper 21 ist als geerdete Anode 21 geschaltet und wird nachfolgend auch durchgängig als Anode 21 bezeichnet. Innerhalb der Vakuumkammer ist eine kreiszylindrische Kathodenanordnung 23 vorgesehen. Innerhalb der Vakuumkammer 22 bildet sich ein Plasma 24 aus, welches nur für kleinvolumige Plasmen ausreichende Bearbeitungsergebnisse liefert und insbesondere keine großvolumigen, homogenen Plasmen gleichmäßiger Plasmadichte erzeugen kann.

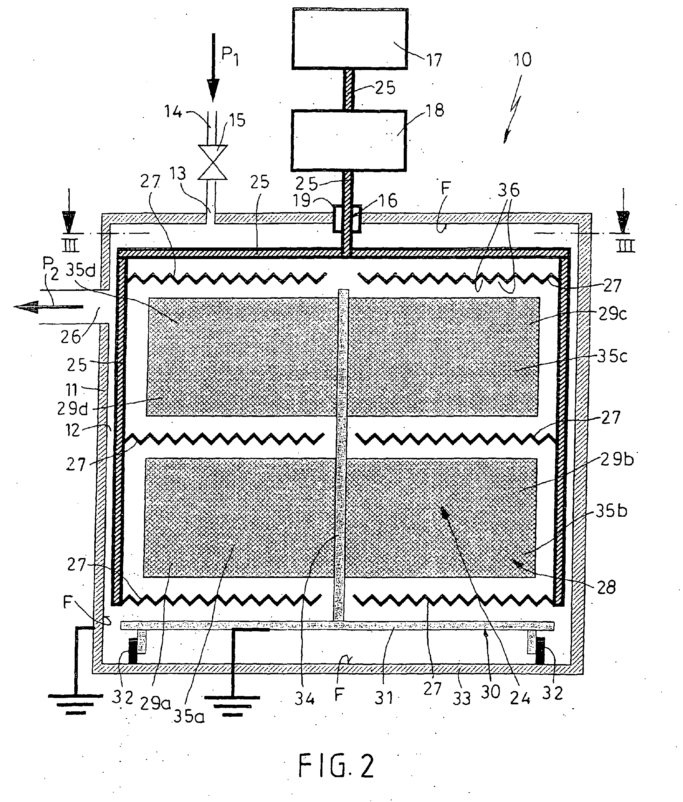

Fig. 2 zeigt eine erfindungsgemäße Vorrichtung 10. Hier ist eine im Querschnitt im wesentlichen quadratische Anode 11 vorgesehen, die beispielsweise kubisch, grundsätzlich aber auch zylindrisch ausgebildet sein kann. Die Anode 11 ist, wie sich insbesondere aus Fig. 2 ergibt, geerdet. Die Anode 11 umgibt einen im wesentlichen geschlossenen Innenraum 12, der die Vakuumkammer darstellt. Die Anode 11 weist eine erste Öffnung 13 auf, durch die ein Arbeitsgas 14, gesteuert über ein Drosselventil 15 in die Vakuumkammer 12 gelangt.

Als Arbeitsgas; oder sogenanntes Neutralgas kommen je nach Anwendungszweck zum Beispiel Argon, Helium, Sauerstoff, Stickstoff, Wasserstoff, Wasserstoffperoxid wie auch Mischungen dieser Gase in Betracht. Andere Gase oder Gasmischungen sind möglich.

Die Anode 11 weist eine zweite Öffnung 16 auf, durch die hindurch Hochfrequenzleistung in die Vakuumkammer 12 eingeleitet wird. Die Hochfrequenzleistung wird in einem HF-Generator 17 erzeugt und über ein Abstimmnetzwerk 18 zu einer Vakuum-Stromdurchführung 19 geleitet.

In der bevorzugten Ausführungsform befinden sich der Hochfrequenzgenerator 17 und das Abstimmnetzwerk 18 außerhalb der Vakuumkammer 12. Das Anpassnetzwerk 18 ist dabei so ausgelegt, daß eine Minimierung der reflektierten Leistung erfolgt.

Eine Besonderheit besteht hier darin, daß Koaxial-Leitungen 25 nicht nur zwischen dem HF-Generator 17 und dem Abstimmnetzwerk 18 bzw. zwischen dem Abstimmnetzwerk 18 und der Vakuumstromdurchführung 19 angeordnet sind, sondern, wie sich insbesondere aus Fig. 2 ergibt, auch innerhalb der Vakuumkammer 12 verlaufen.

Der Hochfrequenzgenerator 17 kann eine Leistungsdichte in dem Prozeßraum zwischen 0,01 und 100 W pro Liter erzeugen. Das Abstimmnetzwerk 18 ist in der Lage, die reflektierte Leistung auf weniger als 2 % der angekoppelten Leistung zu minimieren.

Die eingeleitete Hochfrequenzleistung wird über 50-Ohm-Koaxial-Leitungen 25 innerhalb der Vakuumkammer 12 an die Elektrodenbleche 27 gleichmäßig verteilt.

Die zur Plasmaerzeugung benötigte Energie wird durch den Hochfrequenzgenerator 17 in einer Frequenz zwischen 10 kHz und 100 MHz bereitgestellt. Auf Grund postalischer Einschränkungen verwendet man in der Regel eine Frequenz von 13,56 MHz. Die Anpassung der Hochfrequenzleistung erfolgt mittels des Abstimmnetzwerkes 18.

Eine dritte Öffnung 26 stellt einen Gasauslaß dar, der mit einer nicht dargestellten, bezüglich Fig. 2 im Gasstrom links angeordneten Vakuumpumpe verbunden ist. Der Strom des Arbeitsgases erfolgt somit im wesentlichen entlang der Pfeile P1 und P2. Die nicht dargestellte Vakuumpumpe.sowie ein Drosselventil 15 dienen der Regelung des typischerweise bis zu 10 mbar betragenden Gasdrucks.

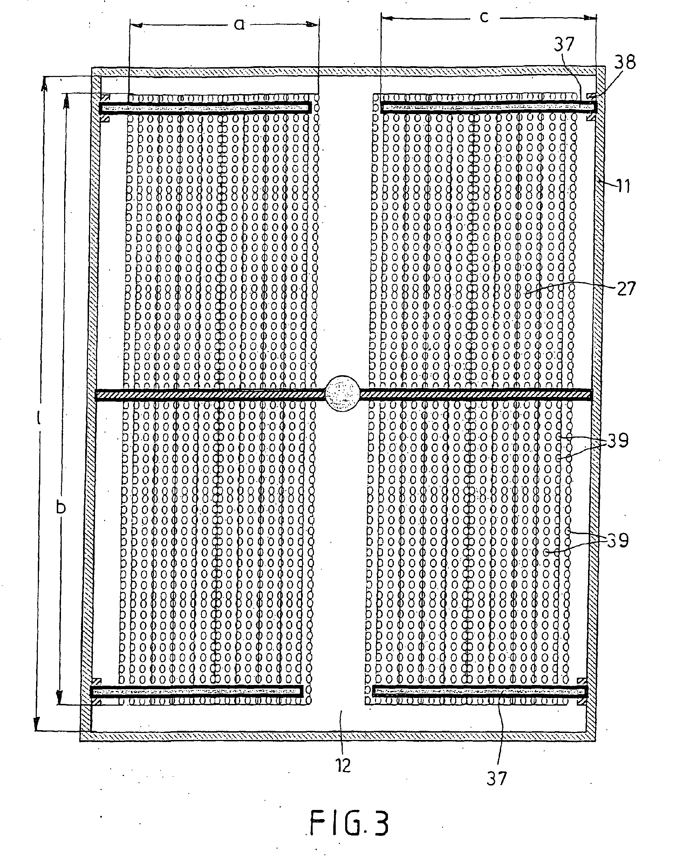

Innerhalb der Vakuumkammer 12 sind bei dem Ausführungsbeispiel gemäß Fig. 2 sechs Elektrodenbleche 27 angeordnet, die gemeinsam die Kathodenanordnung ausbilden. Jedes Elektrodenblech 27 weist einen, wie sich insbesondere aus Fig. 3 ergibt, im wesentlichen rechteckigen Querschnitt mit einer Schmalseite a und einer Breitseite b auf.

Wie sich aus Fig. 2 ergibt, sind die sechs im wesentlichen identischen Elektrodenbleche 27 übereinanderliegend angeordnet, so daß sich der Prozeßraum 28, der gemäß Fig. 2 im wesentlichen von der Innenfläche F der Anode 11 begrenzt wird, in vier Sub-Prozeßräume 29a, 29b, 29c, 29d unterteilt.

Innerhalb der Vakuumkammer 12 ist ein Transportwagen 30 angeordnet, der eine horizontale Bodenplatte 31 umfaßt, die über Rollen 32 auf der Bodenfläche 33 der Anode 11 gelagert ist. Von der Bodenplatte 31 erstreckt sich ein Träger 34 im wesentlichen vertikal nach oben. An dem Trägerelement 34 sind vier Transportkörbe 35a, 35b, 35c, 35d befestigt.

Die durch Plasmaerzeugung zu behandelnden Werkstücke, die beispielsweise gereinigt, sterilisiert oder oberflächenbehandelt werden sollen, befinden sich in den Transportkörben 35a, 35b, 35c, 35d des Transportwagen 30. Der Transportwagen 30 wird außerhalb der Vakuumkammer 12 be- und entladen.

Die Transportkörbe 35a, 35b, 35c, 35d ragen bei in der Vakuumkammer 12 befindlichem Transportwagen 30 in die entsprechenden Sub-Prozeßräume 29a, 29b, 29c, 29d hinein.

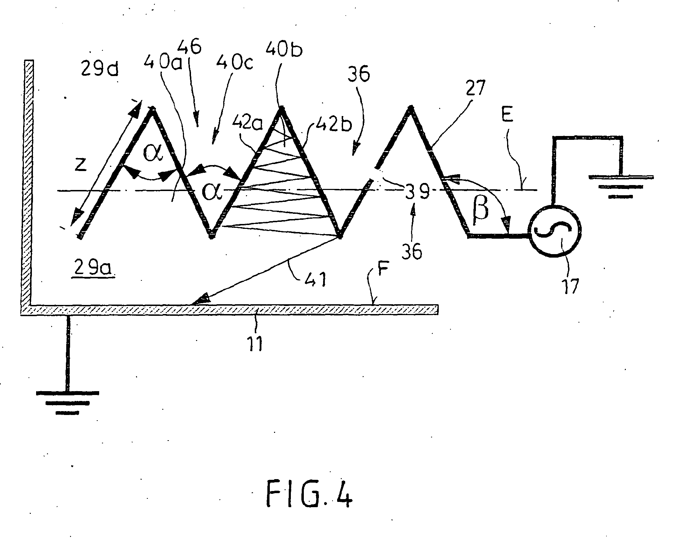

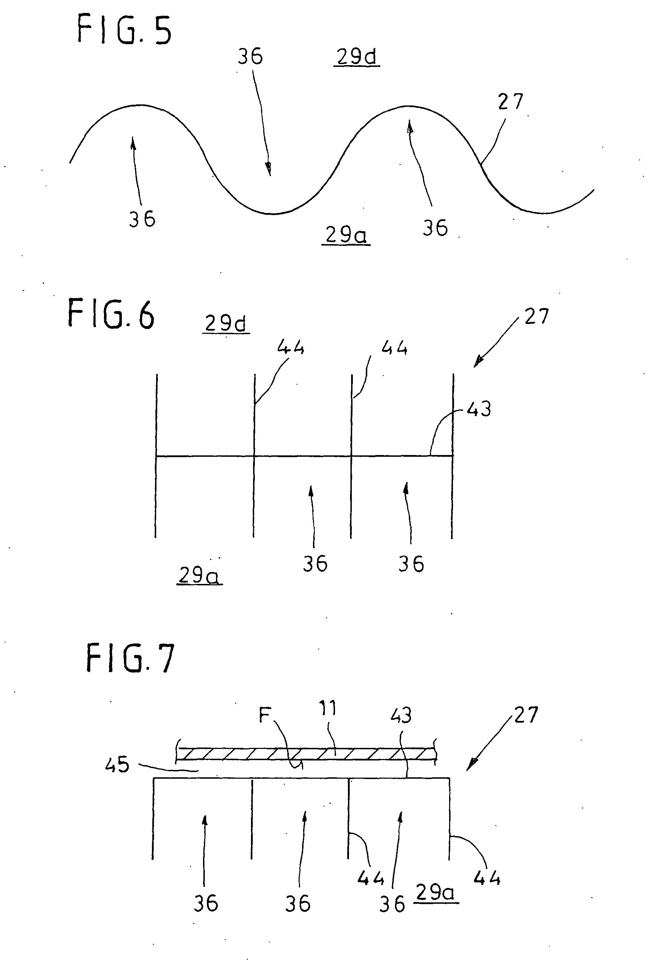

Die Elektrodenbleche 27 weisen jeweils eine Vielzahl taschenartiger Kammern 36 auf. Jede taschenartige Kammer 36 bildet erfindungsgemäß eine Einzel-Hohlkathode aus, innerhalb der ein Hohlkathodeneffekt stattfinden kann. Die besondere Ausbildung der Kammern 36 sowie die physikalischen Prozesse werden später an Hand der Fig. 4 und 7 beschrieben.

Zunächst sei an Hand der Fig. 3 noch die Befestigung der Elektrodenbleche 27 erläutert. Wie sich aus Fig. 3 ergibt, sind Halterungen 37 vorgesehen, die über Isolationsstücke 38 an der Anode 11 befestigt sind. Die beispielsweise aus Metall bestehenden Halterungen 37 können somit von der Anode 11 elektrisch isoliert angeordnet werden.

Die Halterung 37 kann gemäß Fig. 3 so angeordnet werden, daß diese mit ihrer Länge c im wesentlichen der Länge der Schmalseite a entspricht. Die Elektrodenbleche 27 können auf diese Weise mit ihren beiden Enden auf den Halterungen 37 beidendig gelagert sein, so daß eine stabile Anordnung möglich wird.

Aus Fig. 3 wird auch deutlich, daß die Länge I der Vakuumkammer 12 nur unwesentlich größer ist als die Länge b der Kathodenanordnung 27.

Wie sich aus Fig. 3 darüber hinaus ergibt, können die Elektrodenbleche 27 Perforationen 39 aufweisen. Auf die Bedeutung der Perforationen soll bei der nun folgenden Beschreibung der taschenartigen Kammern ebenfalls eingegangen werden.

Fig. 4 zeigt einen Ausschnittsbereich eines Elektrodenbleches 27 und eines Eckbereichs einer Anode 11. An dem Elektrodenblech 27 liegt hochfrequente Leistung, die von dem Hochfrequenz-Generator 17 erzeugt wird, an Es sei darauf hingewiesen, daß die Darstellung gemäß Fig 4 stark schematisiert ist.

Das Elektrodenblech 27 ist derart geformt, daß eine Vielzahl von taschenartigen Kammern 36 nebeneinander liegt. Das Elektrodenblech 27 wurde dabei durch mehrfaches Falten in eine Form überführt, in der es einen sägezahnartigen Querschnitt aufweist. Dies bietet den Vorteil, daß eine erste taschenartige Kammer 40a durch nebeneinanderliegende Anordnung mit einer zweiten Kammer 40b einen gemäß Fig. 4 M-förmigen Querschnitt aufweist. Bei umgekehrter Betrachtungsweise ergibt sich ein im wesentlichen W-förmiger Querschnitt.

Diese Anordnung hat den Vorteil, daß zwischen den beiden taschenartigen Kammern 40a und 40b eine dritte, beim Ausführungsbeispiel im wesentlichen gleich dimensionierte taschenartige Kammer 40c entsteht.

Auf diese Weise können zwei Sub-Prozeßräume 29a und 29d wie folgt beeinflußt werden:
Gemäß Fig. 4 ist in der zweiten taschenartigen Kammer 40b schematisch die Bewegungsbahn eines Elektrons gemäß Pfeilbahn 41 dargestellt. Eine derartige Bahn wird verständlich durch eine physikalische Beschreibung einer taschenartigen Anordnung 40b durch einen Potentialtopf, wobei die beiden Schenkel 42a, 42b der taschenartigen Kammern unendlich hohe Potentialtopfwände darstellen, an denen das Elektron reflektiert wird. Auf Grund der dargestellten Wellenbewegung des Elektrons im elektrischen Feld der Hohlkathode ist der Weg des Elektrons wesentlich länger als bei bekannten, konventionellen planaren Elektrodengeometrien. Daraus ergibt sich eine erhöhte Rate für lonisations- und Anregungsstöße zwischen Elektronen und schweren Teilchen und somit eine höhere Plasmadichte bei gleicher angekoppelter Leistung.

Perforationen 39, die in Fig. 3 lediglich angedeutet sind, ermöglichen einen besonders vorteilhaften Ladungsträgeraustausch durch die Elektrodenbleche 27 hindurch.

Die Anordnung von taschenartigen Kammern, die zu beiden Seiten einer in Fig. 4 mit E bezeichneten Ebene hin gerichtet sind, bietet die Möglichkeit, daß von dieser Mittelebene E weg zu beiden Seiten der Elektrodenanordnung 27 hin mehrfach Elektronenstöße stattfinden können.

Die Länge Z der Schenkel der taschenartigen Kammern 36 wie auch der Winkel α sind zunächst beliebig. Vorteilhafterweise liegt die Schenkellänge Z etwa im Bereich zwischen 1 und 30 cm und der Winkel α in einem Bereich von 30 bis 150°.

An Hand der Fig. 4 wird auch deutlich, daß jede taschenartige Kammer 36 bzw. 40a, 40b, 40c eine offene Seite (s. z.B. Position 46 der dritten taschenartigen Kammer 40c) aufweist, die zu einem Prozeßraum, hier zu dem Prozeßraum 29d hingerichtet ist.

Alternative Ausführungsformen der taschenartigen Kammern 36 bzw. eines derartig geformten Elektrodenbleches 27, welches die taschenartigen Kammern 36 aufweist, sind in den Fig. 5 bis 7 dargestellt. Fig. 5 zeigt eine Anordnung von taschenartigen Kammern, die im wesentlichen entlang einer Sinuskurve verlaufen. Dies bietet insbesondere die Möglichkeit, ein Elektrodenblech auf einfache Weise zu wellen, um die taschenartigen Kammern zu erzeugen.

Bei einer Anordnung, wie sie die Fig. 4 oder die Fig. 5 zeigt, können die taschenartigen Kammern 36 durch Bearbeitung eines flachliegenden Bleches erzeugt werden. Vorteilhafterweise handelt es sich um ein Aluminiumblech. Es kommen grundsätzlich auch andere Metalle in Betracht.

Fig. 6 zeigt eine alternative Anordnung von taschenartigen Kammern 36, die einen im wesentlichen rechteckigen Querschnitt aufweisen. Hier sind von einem zentralen Mittelblech 43 lotrecht abgehend eine Vielzahl von Vertikalblechen 44 befestigt. Auch diese Anordnung liefert zufriedenstellende Ergebnisse.

Entscheidend bei der Ausführungsform der Kathodenanordnung 27 ist, daß eine alternierende, abwechselnde Abfolge von taschenartigen Kammern 36 vorgesehen ist, die zu unterschiedlichen Sub-Prozeßräumen 29a, 29d hin gerichtet sind.

Grundsätzlich kann auch vorgesehen sein, daß die taschenartigen Kammern 36 lediglich durch Seitenwände angedeutet sind und der Kammerboden nicht vollständig geschlossen ist.

Fig. 7 zeigt eine weitere Konfiguration einer Kathodenanordnung 27, die hier jedoch nicht als einzelnes Blech ausgeführt ist. Die taschenartigen Kammern 36 werden hier dadurch erzeugt, daß von einem Mittelblech 43 nur zu einer Seite eines Prozeßraums 29a hin Vertikalbleche abgehen und taschenartige Kammern 36 gebildet werden.

Eine Anordnung gemäß Fig. 7 kommt beispielsweise im Bereich der Innenfläche F einer Anode 11 in Betracht, bei der der zur Verfügung stehende Raum 45 zwischen der Anode 11 und dem Mittelblech 43 zu gering ist, als daß hier die Anordnung eines Prozeßraumes sinnvoll wäre.

Die in Fig. 2 dargestellte besondere Anordnung von Elektrodenblechen 27 ist lediglich beispielhaft. Grundsätzlich kann eine Vielzahl weiterer Sub-Prozeßräume 29 durch die Unterteilung eines großen Prozeßraumes 28 durch eine nahezu beliebige Anordnung der Kathoden 27 erreicht werden.

Das Vorsehen der taschenartigen Kammern 36, 40 ermöglicht das Auftreten eines Hohlkathodeneffekts über einen sehr großen Druckbereich zwischen 0,01 mbar bis zu mehreren mbar. Der Hohlkathodeneffekt tritt dabei auf beiden Seiten der Kathodenanordnung 27 auf. Grundsätzlich sind die Dimensionen der taschenartigen Kammern frei wählbar.

Für den Fall, daß wie Fig. 2 zeigt, der Transportwagen 30 elektrisch leitend mit der Anode 11 verbunden ist, dient der elektrisch geerdete Transportwagen 30 einschließlich seiner Körbe 35a, 35b, 35c, 35d ebenso wie die geerdete Kammer als Anode.

## Patentansprüche

1. Vorrichtung zur Erzeugung eines Niedertemperatur-Plasmas,
umfassend eine hohle Anode (11), die eine im Wesentlichen geschlossene Vakuumkammer (12) definiert, innerhalb welcher wenigstens eine Kathodenanordnung vorgesehen ist, welche einen Prozessraum (28) zumindest teilweise begrenzt,
wobei die Kathodenanordnung eine Vielzahl von zu dem Prozessraum (28, 29a, 29b, 29c, 29d) hin offenen, taschenartigen Kammern (36, 40a, 40b, 40c) umfasst, die eine Vielzahl von Einzel-Hohlkathoden bilden,
**dadurch gekennzeichnet,**
**dass** die Kathodenanordnung (27) von mindestens einem gefalteten oder gewellten Elektrodenblech (27) gebildet ist, welches die taschenartigen Kammern (36, 40a, 40b, 40c) aufweist.

2. Vorrichtung nach Anspruch 1,
**dadurch gekennzeichnet,**
**dass** der Prozessraum (28) von der Kathodenanordnung in mehrere Sub-Prozessräume (29a, 29b, 29c, 29d) unterteilt ist.

3. Vorrichtung nach Anspruch 2,
**dadurch gekennzeichnet,**
**dass** wenigstens eine taschenartige Kammer (40c) mit ihrer offenen Seite (46) zu einem ersten Sub-Prozessraum (29d) hingerichtet ist und wenigstens eine weitere taschenartige Kammer (40a, 40b) mit ihrer offenen Seite zu einem zweiten Sub-Prozessraum (29a) hingerichtet ist.

4. Vorrichtung nach einem der vorangegangenen Ansprüche,
**dadurch gekennzeichnet,**
**dass** jeweils zwei benachbarte taschenartige Kammern (40a, 40b) unter Ausbildung einer im Wesentlichen W-förmigen Struktur miteinander verbunden sind.

5. Vorrichtung nach einem der vorangegangenen Ansprüche,
**dadurch gekennzeichnet,**
**dass** eine erste und eine zweite taschenartige Kammer (40a, 40b) nebeneinander derart angeordnet sind, dass sie zwischen sich eine dritte, entgegengesetzt gerichtete Kammer (40c) ausbilden.

6. Vorrichtung nach Anspruch 1,
**dadurch gekennzeichnet,**
**dass** die taschenartigen Kammern (36, 40a, 40b, 40c) entlang unterschiedlicher Ebenen (E) angeordnet sind.

7. Vorrichtung nach einem der vorangegangenen Ansprüche,
**dadurch gekennzeichnet,**
**dass** innerhalb des Prozessraums (28) ein Transportwagen (30) anordenbar ist.

8. Vorrichtung nach Anspruch 7,
**dadurch gekennzeichnet,**
**dass** der Transportwagen (30) im Prozessraum (28) geerdet, insbesondere mit der Anode elektrisch verbunden, angeordnet ist.

9. Vorrichtung nach Anspruch 8,
**dadurch gekennzeichnet,**
**dass** die Erdung des Transportwagens (30) über einen Kontakt der Rollen (32) des Transportwagens (30) mit der Anode (11) oder über einen Schleifkontakt erfolgt.

10. Vorrichtung nach Anspruch 7,
**dadurch gekennzeichnet,**
**dass** der Transportwagen (30) im Prozessraum (28) elektrisch von der Anode (11) isoliert angeordnet ist.

11. Vorrichtung nach einem der Ansprüche 7 bis 10,
**dadurch gekennzeichnet,**
**dass** der Transportwagen (30) mehrere Transportkörbe (35a, 35b, 35c, 35d) umfasst.

12. Vorrichtung nach Anspruch 11,
**dadurch gekennzeichnet,**
**dass** die Anordnung der Transportkörbe (35a, 35b, 35c, 35d) einer Anordnung von Sub-Prozessräumen (29a, 29b, 29c, 29d) entspricht.

13. Vorrichtung nach einem der vorangegangenen Ansprüche,
**dadurch gekennzeichnet,**
**dass** die taschenartige Kammer (36, 40a, 40b, 40c) im Querschnitt im Wesentlichen dreieckförmig ausgebildet ist.

14. Vorrichtung nach Anspruch 13,
**dadurch gekennzeichnet,**
**dass** die taschenartige Kammer (36, 40a, 40b, 40c) von zwei Schenkelflächen (42a, 42b) gebildet ist, die unter einem Winkel ( alpha ) im Bereich zwischen 30° und 150° zueinander stehen.

15. Vorrichtung nach Anspruch 13 oder 14,
**dadurch gekennzeichnet,**
**dass** die Schenkellänge (Z) eines Dreiecks im Bereich zwischen 0,5 und 30 cm liegt.

16. Vorrichtung nach einem der vorangegangenen Ansprüche,
**dadurch gekennzeichnet,**
**dass** die taschenartigen Kammern (36, 40a, 40b, 40c) Perforationen (39) aufweisen.

17. Vorrichtung nach Anspruch 16,
**dadurch gekennzeichnet,**
**dass** die Fläche der Perforationen (39) einen Anteil an der Gesamtfläche der Wände (42a, 42b) der taschenartigen Kammern (36, 40a, 40b, 40c) von weniger als 80 % besitzen.

18. Vorrichtung nach einem der vorangegangenen Ansprüche,
**dadurch gekennzeichnet,**
**dass** die taschenartigen Kammern zylindrisch langgestreckt ausgebildet sind.

19. Vorrichtung nach Anspruch 18,
**dadurch gekennzeichnet,**
**dass** die Länge (b) der taschenartigen Kammern (36, 40a, 40b; 40c) nur geringfügig kürzer ist als die Länge (L) der Vakuumkammer (12).

20. Vorrichtung nach einem der vorangegangenen Ansprüche,
**dadurch gekennzeichnet,**
**dass** das Plasma (24) gepulst ist.

## Claims

1. Equipment for generating a low energy plasma,
consists of a hollow anode (11), that is substantially enclosed in a vacuum chamber (12), inside of which at least one cathode assembly is provided, which delimits a process chamber (28) at least partially,
where the cathode assembly consists of a number of open chambers (36, 40a, 40b, 40c) to the process chamber (28, 29a, 29b, 29c, 29d), that are make up a number of individual hollow cathodes, **characterized,**
**in that** the cathode assembly (27) is made up of at least one folded or corrugated electrode sheet (27), which defines the pocket-like chambers (36, 40a, 40b, 40c).

2. Equipment according to claim 1,
**characterized,**
**in that** the process chamber (28) is divided by the cathode assemblies into several sub-process chambers (29a, 29b, 29c, 29d).

3. Equipment according to claim 2,
**characterized,**
**in that** at least one pocket-like chamber (40c) is aligned with its open side (46) towards a first sub-process chamber (29d) and at least one further pocket-like chamber (40a, 40b) with its open side aligned to a second sub-process chamber (29a).

4. Equipment according to the preceding claims,
**characterized,**
**in that** two neighbouring pocket-like chambers (40a, 40b) are connected together so that they appear to form a W-shaped structure.

5. Equipment according to the preceding claims,
**characterized,**
**in that** a first and a second pocket-like chamber (40a, 40b) are arranged next to each other so that a third, oppositely aligned chamber (40c) can be fit between them.

6. Equipment according to claim 1,
**characterized,**
**in that** the pocket-like chambers (36, 40a, 40b, 40c) are arranged along different planes (E).

7. Equipment according to the preceding claims,
**characterized,**
**in that** within the process chamber (28) a transport-carriage (30) can be arranged.

8. Equipment according to claim 7,
**characterized,**
**in that** the transport-carriage (30) is arranged in the process chamber (28) is earthed, in particular connected electrically to the anode.

9. Equipment according to claim 8,
**characterized,**
**in that** the earthing of the transport-carriage (30) is done by the rollers (32) of the transport-carriage (30) contacting the anode (11) or using a sliding contact.

10. Equipment according to claim 7,
**characterized,**
**in that** the transport-carriage (30) in the process chamber (28) is arranged so that it is electrically isolated from the anode (11):

11. Equipment according to claims 7 to 10,
**characterized,**
**in that** the transport-carriage (30) consists of several transport baskets (35a, 35b, 35c, 35d).

12. Equipment according to claim 11,
**characterized,**
**in that** the arrangement of the transport baskets (35a, 35b, 35c, 35d) is arranged corresponding to the sub-process chambers (29a, 29b, 29c, 29d).

13. Equipment according to the preceding claims,
**characterized,**
**in that** the pocket-like chambers (36, 40a, 40b, 40c) are shown as being substantially triangular in cross-section.

14. Equipment according to claim 13,
**characterized,**
**in that** the pocket-like chambers (36, 40a, 40b, 40c) are shown with two arm surfaces (42a, 42b), that form an angle (alpha) which lies between 30° and 15° to each other.

15. Equipment according to claim 13 or 14,
**characterized,**
**in that** the arm length (Z) of a triangle lies in a range between 0.5 cm and 30 cm.

16. Equipment according to the preceding claims,
**characterized,**
**in that** the pocket-like chambers (36, 40a, 40b, 40c) have perforations (39).

17. Equipment according to claim T6,
**characterized,**
**in that** the surfaces of the perforations (39) cover a total area of the walls (42a, 42b) of the pocket like chambers (36, 40a, 40b, 40c) of less than 80 %.

18. Equipment according to the preceding claims,
**characterized,**
**in that** the pocket-like chambers are shown as being cylindrically stung-out.

19. Equipment according to claim 18,
**characterized,**
**in that** the length (b) of the pocket-like chambers (36, 40a, 40b, 40c) is only slightly shorter than the length (L) of the vacuum chamber (12).

20. Equipment according to the preceding claims,
**characterized,**
**in that** the plasma (24) is pulsed.

## Revendications

1. Dispositif permettant de fabriquer un plasma à basse température,
comprenant une anode creuse (11) qui définit une chambre sous vide (12) essentiellement fermée, au sein de laquelle au moins un agencement de cathode est prévu, lequel délimite au moins en partie un espace de traitement (28)
l'agencement de la cathode comprenant un grand nombre de chambres (36, 40a, 40b, 40c) de type sac ouvertes vers l'espace de traitement (28, 29a, 29b, 29c, 29d) qui forment des cathodes creuses uniques, **caractérisé en ce que**
l'agencement de la cathode (27) est formé par au moins une tôle d'électrodes (27) ondulée ou pliée qui présente des chambres (36, 40a, 40b, 40c) de type sac.

2. Dispositif selon la revendication 1,
**caractérisé en ce que**
l'espace de traitement (28) est sous-divisé de par l'agencement des cathodes en plusieurs sous-espaces de traitement (29a, 29b, 29c, 29d).

3. Dispositif selon la revendication 2,
**caractérisé en ce que**
au moins une chambre de type sac (40c) est orientée avec sa partie ouverte (46) vers un premier sous-espace de traitement (29d) et au moins une autre chambre de type sac (40a, 40b) est orientée avec sa partie ouverte vers un deuxième sous-espace de traitement (29a).

4. Dispositif selon l'une quelconque des revendications précédentes,
**caractérisé en ce que**
à chaque fois deux chambres de type sac (40a, 40b) voisines sont liées l'une à l'autre par la formation d'une structure essentiellement en forme de W.

5. Dispositif selon l'une quelconque des revendications précédentes,
**caractérisé en ce que**
une première et une deuxième chambre de type sac (40a, 40b) sont agencées l'une à côté de l'autre de telle sorte qu'elles forment entre elles une troisième chambre (40c) orientée dans le sens contraire.

6. Dispositif selon la revendication 1,
**caractérisé en ce que**
les chambres de type sac (36, 40a, 40b, 40c) sont agencées le long de plans différents (E).

7. Dispositif selon l'une quelconque des revendications précédentes,
**caractérisé en ce que**
au sein de l'espace de traitement (28), un chariot de transport (30) peut être agencé.

8. Dispositif selon la revendication 7,
**caractérisé en ce que**
le chariot de transport (30) mis à la terre, notamment relié électriquement à l'anode, est agencé dans l'espace de traitement (28).

9. Dispositif selon la revendication 8,
**caractérisé en ce que**
la mise à la terre du chariot de transport (30) se fait par un contact des roulettes (32) du chariot de transport (30) avec l'anode (11) ou par un contact glissant.

10. Dispositif selon la revendication 7,
**caractérisé en ce que**
le chariot de transport (30) isolé électriquement de l'anode (11) est agencé dans l'espace de traitement (28).

11. Dispositif selon l'une quelconque des revendications 7 à 10,
**caractérisé en ce que**
le chariot de transport (30) comprend plusieurs nacelles de transport (35a, 35b, 35c, 35d).

12. Dispositif selon la revendication 11,
**caractérisé en ce que**
l'agencement des nacelles de transport (35a, 35b, 35c, 35d) correspond à un agencement des sous-espaces de traitement (29a, 29b, 29c, 29d).

13. Dispositif selon l'une quelconque des revendications précédentes,
**caractérisé en ce que**
la chambre de type sac (36, 40a, 40b, 40c) est formée dans une section transversale essentiellement de forme triangulaire.

14. Dispositif selon la revendication 13,
**caractérisé en que**
la chambre de type sac (36, 40a, 40b, 40c) est formée par deux surfaces latérales (42a, 42b) qui se croisent selon un angle (alpha) dans une plage comprise entre 30° et 150°.

15. Dispositif selon la revendication 13 ou 14,
**caractérisé en ce que**
la longueur du côté (Z) d'un triangle s'inscrit dans une plage comprise entre 0,5 et 30 cm.

16. Dispositif selon l'une quelconque des revendications précédentes,
**caractérisé en ce que**
les chambres de type sac (36, 40a, 40b, 40c) présentent des perforations (39).

17. Dispositif selon la revendication 16,
**caractérisé en ce que**
les surfaces des perforations (39) représentent moins de 80 % de la surface totale des parois (42a, 42b) des chambres de type sac (36, 40a, 40b, 40c).

18. Dispositif selon l'une quelconque des revendications précédentes,
**caractérisé en ce que**
les chambres de type sac ont des formes cylindriquement allongées.

19. Dispositif selon la revendication 18,
**caractérisé en ce que**
la longueur (b) des chambres de type sac (36, 40a, 40b, 40c) est légèrement inférieure à la longueur (L) de la chambre sous vide (12).

20. Dispositif selon l'une quelconque des revendications précédentes,
**caractérisé en ce que**
le plasma (24) est pulsé.
